# EUROPÄISCHE PATENTANMELDUNG

(11) **EP 2 226 864 A1**
(43) Veröffentlichungstag der Anmeldung: **08.09.2010**
(21) Anmeldenummer: 10150008.0
(22) Anmeldetag: 04.01.2010
(51) Int. Cl.: H01L 41/09

(54) **Schwingungsantrieb**

(30) Priorität: 02.03.2009 DE 102009001254
(71) Anmelder: Robert Bosch GmbH, 70442 Stuttgart (DE)
(72) Erfinder: Mendgen, Ralf, 71665, Vaihingen (DE); Hagemann, Benjamin, 70839, Gerlingen (DE)

(57) **Zusammenfassung**

Die Erfindung betrifft einen Schwingungsantrieb (10; 10a; 10b), insbesondere für Kraftfahrzeuganwendungen, weist wenigstens zwei zu Schwingungen anregbare Antriebselemente (11, 12) auf, welche in Wirkverbindung mit wenigstens einem Abtriebselement (23; 30, 31; 30a, 31 a) angeordnet sind. Erfindungsgemäß ist vorgesehen, dass das erste der wenigstens zwei Antriebselemente (11) mit einer Seite (17) mit einem ortfesten oder zu bewegenden Objekt (18; 35) verbunden ist, und dass das zweite der wenigstens zwei Antriebselemente (12) ausschließlich an dem ersten Antriebselement (11) an dessen dem ortsfesten oder zu bewegenden Objekt (18; 35) gegenüberliegenden Seite befestigt ist. Dadurch lässt sich ein im Aufbau relativ einfacher und zuverlässig arbeitender Schwingungsantrieb (10; 10a; 10b) verwirklichen.

## Beschreibung

### Stand der Technik

Die Erfindung betrifft einen Schwingungsantrieb, insbesondere für Kraftfahrzeuganwendungen, nach dem Oberbegriff des Anspruchs 1.

Ein derartiger Schwingungsantrieb ist aus der EP 0155694 B1 bekannt. Der als Stößelantrieb ausgeführte Schwingungsantrieb umfasst zwei winklig zueinander angeordnete, piezoelektrische Aktuatoren, mit denen ein Antriebselement (Stößel) zu Schwingungen anregbar ist, um eine Schiene (Abtriebselement) translatorisch anzutreiben. Dabei sind die beiden Aktuatoren über ein Brückenelement, das gleichzeitig das Stößelelement ausbildet, miteinander gekoppelt. Das Brückenelement ist an jeweils einer Stirnseite des Aktuators angeordnet. Die andere Stirnseite jedes Aktuators ist ortsfest angeordnet bzw. fixiert. Das Antriebselement wird mittels einer Schraubenfeder in eine Anpressrichtung gegen das Abtriebselement gepresst, um eine ausreichende Kraftübertragung durch Reibschluss zu garantieren. Der bekannte Schwingungsantrieb ist im Aufbau relativ aufwändig und benötigt relativ viele Einzelteile, die präzise miteinander verbaut werden müssen. Ein weiterer Nachteil besteht dann, wenn der Schwingungsantrieb in Resonanz betrieben werden soll. Dies ist bei einem derartigen Antrieb, der üblicherweise mit Frequenzen größer 20 kHz betrieben wird der Fall, da sich im Resonanzfall aufgrund der bekannten Resonanzüberhöhung besonders große Schwingungsamplituden ergeben, die zu besonders hohen Antriebsgeschwindigkeiten und -kräften führen. Problematisch bei einem derartigen Resonanzbetrieb ist es, dass es kaum möglich ist, die Resonanzfrequenzen der beiden piezoelektrischen Aktuatoren in Übereinstimmung zu bringen. Daher ist es nur sehr schwierig, das Gesamtsystem in Resonanz zu betreiben, insbesondere vor dem Hintergrund sich ändernder Umgebungsbedingungen und der Eigenerwärmung der piezoelektrischen Aktuatoren. Dies führt zu erheblichen Anforderungen an die Steuerelektronik.

### Offenbarung der Erfindung

Der Erfindung liegt die Aufgabe zugrunde, einen möglichst kostengünstig herstellbaren sowie bauraum- und gewichtsoptimierten Schwingungsantrieb anzugeben. Gleichzeitig sollen die angesprochenen Resonanzprobleme vermieden werden und somit ein besonders zuverlässig arbeitender Schwingungsantrieb verwirklicht werden.

Diese Aufgabe wird mit einem Schwingungsantrieb mit den Merkmalen des Anspruchs 1 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen.

Der Erfindung liegt der Gedanke zugrunde, beim Vorhandensein zweier Antriebselemente das zweite Antriebselement an einer Seite des ersten Antriebselements zu befestigen. Das erste Antriebselement dient somit gleichzeitig als Träger für das zweite Antriebselement, so dass auf ein aus dem Stand der Technik bekanntes Brückenelement verzichtet werden kann. Gleichzeitig wird durch eine derartige Anordnung eine Entkopplung der beiden Antriebselemente ermöglicht, die sich positiv auf die angesprochene Resonanzproblematik auswirkt.

Besonders vorteilhaft ist eine senkrechte Anordnung der Antriebselemente in Verbindung mit einer rechtwinkligen bzw. parallelen Anordnung zum wenigstens einen Abtriebselement bzw. zu dem zu bewegenden Objekt. Dadurch wird jedem der beiden Antriebselemente nur eine einzige Funktion, Vorschub bzw. Übertragung des Vorschubs zugeordnet. Dies vereinfacht den Aufbau eines Übertragungsmechanismus.

Ein besonders kompakter Aufbau lässt sich bei der Verwendung eines zweiten Antriebselements verwirklichen, wenn dieses mit seinem Endbereich am ersten Antriebselement angeordnet ist. Dadurch lässt sich der gesamte Hub des zweiten Antriebselements zum Klemmen nutzen, so dass die Baugröße des zweiten Antriebselements relativ gering ist. Weiterhin genügt ein einziges Abtriebselement.

Bei einer mittigen Anordnung des zweiten Antriebselements am ersten Antriebselement lassen sich demgegenüber Querkräfte beim Klemmen des bzw. der Abtriebselemente vermeiden, so dass das erste Antriebselement mechanisch bezüglich seiner Stabilität relativ einfach aufgebaut sein kann.

Besonders vorteilhaft ist die Ausbildung der Antriebselemente als Piezoaktuatoren. Dadurch lässt sich ein besonders kompakter Schwingungsantrieb ermöglichen, der bei geringem Gewicht eine hohe Betriebszuverlässigkeit aufweist.

Bei der Verwendung von Piezoakuatoren ist es durch eine zeitlich versetzte Ansteuerung der Piezoaktuatoren auf einfache Weise möglich, die Bewegungsrichtung des Schwingungsantriebs ohne eine zusätzliche Mechanik zu ändern.

Darüber hinaus ist es bei der Verwendung eines nach dem d31-Effekt arbeitenden Piezoaktuators möglich, Schutzmaßnahmen, die zum Halten des bzw. der Abtriebselemente bzw. des zu bewegenden Objekts dienen, zumindest zu vereinfachen, da sich in stromlosem Zustand des betreffenden Piezoaktuators eine Klemmfunktion verwirklichen lässt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

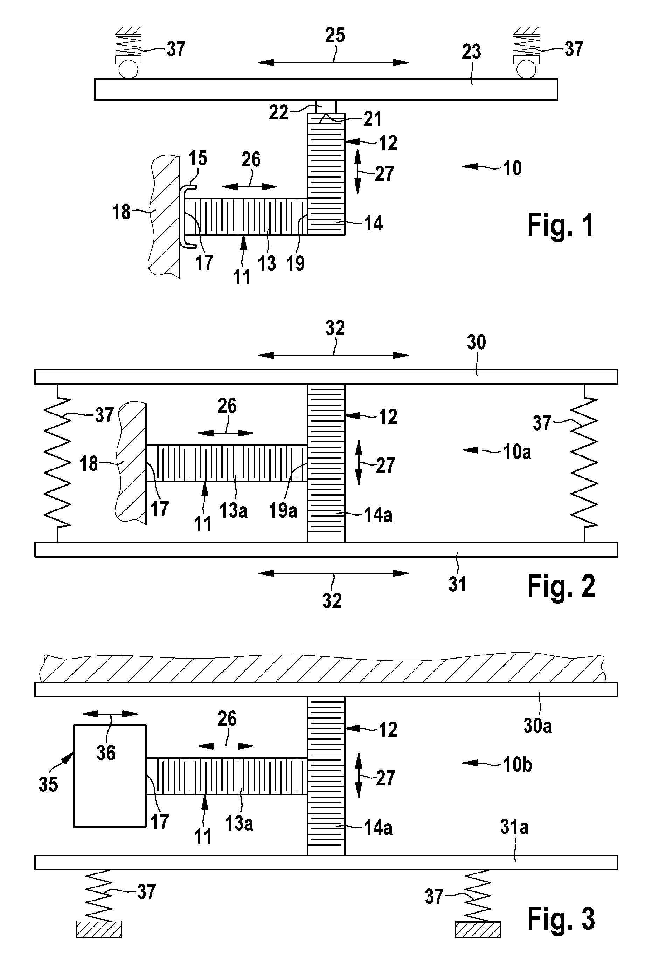

- Fig. 1 bis Fig. 3: jeweils erfindungsgemäße Schwingungsantriebe in schematischer Darstellung.

In den Figuren sind gleiche Elemente und Elemente mit gleicher Funktion mit den gleichen Bezugszeichen gekennzeichnet.

In Fig. 1 ist ein Schwingungsantrieb 10 dargestellt, der insbesondere für Kraftfahrzeuganwendungen vorgesehen ist. Eine derartige typische Kraftfahrzeuganwendung stellt ein Fensterheberantrieb dar, bei dem entsprechend eines Bedienerwunsches ein Fenster in der Türe des Kraftfahrzeugs geöffnet bzw. geschlossen werden soll. Der Schwingungsantrieb 10 weist hierzu zwei Antriebselemente 11, 12 auf. Die Antriebselemente 11, 12 sind hierbei bevorzugt als Piezoakuatoren 13, 14 und besonders bevorzugt als Vielschichtpiezoaktuatoren ausgebildet. Bei den Piezoaktuatoren 13, 14 werden zwei Arten unterschieden, Piezoaktuatoren 13, 14, die nach dem d33-Effekt arbeiten, und solche, die nach dem d31-Effekt arbeiten. Letztere, die mittels des d31-Effekts arbeiten, kontrahieren bei Anlegen einer Spannung in Längsrichtung, während erstere sich beim Anlegen einer Spannung in Längsrichtung ausdehnen. Fertigungstechnisch lassen sich Piezoaktuatoren 13, 14, die nach dem d31-Effekt arbeiten kostengünstiger herstellen, wobei sie einen geringeren Hub aufweisen als Piezoaktuatoren 13, 14, die nach dem d33-Effekt arbeiten.

Zumindest der eine Piezoaktuator 13 ist einseitig in einem Gehäuse 15 aufgenommen, das lediglich in Fig. 1, und dort auch nur angedeutet, dargestellt ist. Bei dem in Fig. 1 dargestellten ersten Ausführungsbeispiel ist der erste Piezoaktuator 13 mit seinem Gehäuse 15 an einer Stirnseite 17 des Piezoaktuators 13 an einem als ortsfester Lagerung 18 ausgebildeten Objekt befestigt bzw. fixiert. An der anderen Stirnseite 19 des ersten Piezoaktuators 13 ist der zweite Piezoaktuator 14 befestigt. Die Verbindung zwischen den beiden Piezoaktuatoren 13, 14 kann hierbei durch Kleben, Sintern, Löten mit einem metallischen oder glasartigen Lot oder durch Klemmen erzeugt werden. Alternativ können die Piezoaktuatoren 13, 14 mittels die Piezoaktuatoren 13, 14 vorspannenden Hülsenfedern miteinander verbunden werden, wobei die Hülsenfedern als Bestandteile der Piezoaktuatoren 13, 14 anzusehen sind. Der zweite Piezoaktuator 14 weist an einer Stirnseite 21 ein Klemmelement 22 auf, das in Wirkverbindung mit einem als Schiene ausgebildeten Abtriebselement 23 gebracht werden kann. Das Abtriebselement 23 ist zum Beispiel mit dem zu bewegenden Fenster des Kraftfahrzeugs direkt verbunden bzw. gekoppelt, so dass eine Bewegung des Abtriebselements 23 in Richtung des Doppelpfeils 25 einem Öffnen bzw. Schließen des Fensters entspricht. Wie sich aus Fig. 1 ergibt, ist das Abtriebselement 23 in Richtung Piezoaktuator 14 vorgespannt, um für eine ausreichende Kontaktkraft Sorge zu tragen. Ggf. kann (nicht angezeigt) eine geeignete Abstützung an den Piezoaktuatoren 13, 14 zur Aufnahme dieser Vorspannkraft vorgesehen werden.

Bei der in Fig. 1 dargestellten Anordnung ist der erste Piezoaktuator 13 mit seiner Längsachse parallel zum Abtriebselement 23 angeordnet, so dass die mit dem Doppelpfeil 26 bezeichneten Schwingungsrichtungen des ersten Piezoaktuators 13 parallel zu den Bewegungsrichtungen (Doppelpfeil 25) des Abtriebselements 23 verlaufen. Der zweite Piezoaktuator 14, dessen Schwingungsrichtungen durch den Doppelpfeil 27 dargestellt sind, ist mit seiner Längsachse senkrecht zum ersten Piezoaktuator 13 und zum Abtriebselement 23 angeordnet. Ferner erkennt man anhand Fig. 1, dass der zweite Piezoaktuator 14 mit der dem Klemmelement 22 gegenüberliegenden Seite bzw. Endbereich am ersten Piezoaktuator 13 angeordnet ist.

Unter der Annahme, dass beide Piezoaktuatoren 13, 14 nach dem d33-Effekt arbeiten, funktioniert der Schwingungsantrieb 10 wie folgt: Beim Anlegen einer Spannung an den zweiten Piezoaktuator 14 dehnt sich dieser aus, so dass das Klemmelement 22 in Anlagekontakt mit dem Abtriebselement 23 gelangt. Anschließend wird eine Spannung an den ersten Piezoaktuator 13 angelegt, so dass sich dieser ebenfalls in seiner Längsrichtung (in die eine Richtung des Doppelpfeils 26) ausdehnt. Durch die kraftschlüssige Verbindung zwischen dem Abtriebselement 23 und dem Klemmelement 22 wird hierbei das Abtriebselement 23 (bzw. das mit diesem gekoppelte Fenster) um den Betrag des Hubes des ersten Piezoaktuators 13 bewegt. Anschließend wird die Spannung am zweiten Piezoaktuator 14 unterbrochen bzw. reduziert, so dass dessen Längsausdehnung sich reduziert, und somit sich auch das Klemmelement 22 vom Abtriebselement 23 löst. Jetzt wird die Spannung am ersten Piezoaktuator 13 ebenfalls unterbrochen bzw. reduziert, so dass dieser wieder zusammen mit dem zweiten Piezoaktuator 14 seine ursprüngliche (nicht ausgedehnte) Lage erlangt. Anschließend wiederholen sich die Ansteuerungen der beiden Piezoaktuatoren 13, 14 in der beschriebenen Art und Weise.

Da ein derartiger Schwingungsantrieb 10 zum Beispiel typischerweise mit einer Frequenz größer 20 kHz angesteuert wird, lässt sich, obwohl der durch den ersten Piezoaktuator 13 erzeugbare Hub lediglich im Mikrometerbereich liegt, eine makroskopische und gleichförmige Bewegung des Abtriebselements 23 erzielen. Wesentlich ist lediglich, dass die beiden Piezoaktuatoren 13, 14 mit einer Phasenverschiebung von 90 Grad angesteuert werden. Die Vorschubrichtung, das heißt ob das Abtriebselement 23 (und somit das Fenster) in die eine oder die andere Richtung des Doppelpfeils 25 bewegt wird, hängt nur davon ab, welcher der beiden Piezoaktuatoren 13, 14 zuerst angesteuert wird. Auch lässt sich der Schwingungsantrieb mit niedrigen Frequenzen als Stellantrieb betreiben.

Zusätzlich wird erwähnt, dass es beim oben beschriebenen Ausführungsbeispiel vorteilhaft sein kann, einen nach dem d31-Effekt arbeitenden zweiten Piezoaktuator 14 zu verwenden. Dies hat den Vorteil, dass das Abtriebselement 23 (bzw. das Fenster) im unbestromten Zustand des zweiten Piezoaktuators 14 durch das Klemmelement 22 gehalten wird. Dadurch sind ggf. zusätzliche Halte- oder Klemmmittel, die eine Bewegung des Abtriebselements 23 (und damit des Fensters) verhindern sollen, nicht erforderlich oder konstruktiv einfacher auslegbar.

Bei dem in Fig. 2 dargestellten zweiten Ausführungsbeispiel der Erfindung sind bei dem Schwingungsantrieb 10a zwei zueinander parallel angeordnete Abtriebselemente 30, 31 vorgesehen. Die beiden Abtriebselemente 30, 31 sind bevorzugt miteinander starr verbunden (nicht dargestellt), so dass sie synchron in Richtung der Doppelpfeile 32 bewegt werden. Insbesondere sind die beiden Abtriebselemente 30, 31 wieder mit einem Fenster eines Kraftfahrzeugs gekoppelt. Im Unterschied zum ersten Schwingungsantrieb 10 ist der zweite Piezoaktuator 14a seitlich insbesondere mittig an der Stirnseite 19a des ersten Piezoaktuators 13a befestigt. Die Funktionsweise des Schwingungsantriebs 10a unterscheidet sich grundsätzlich nicht von der Funktionsweise des Schwingungsantriebs 10. Jedoch lässt sich aufgrund der mittigen Anordnung des zweiten Piezoaktuator 14a in Richtung des jeweiligen Abtriebselements 30, 31 betrachtet, im Vergleich zum ersten Ausführungsbeispiel, nur etwa der halbe Hub am Piezoaktuator 14a erzeugen. Vorteilhaft bei dem Schwingungsantrieb 10a ist jedoch, dass im Gegensatz zum Schwingungsantrieb 10 gemäß Fig. 1 keine Querkräfte auf den ersten Piezoaktuator 13a erzeugt werden. Weiterhin wird zum Erzielen einer bestimmten Haltekraft nur jeweils die halbe Anlagekraft am Abtriebselement 30, 31 im Vergleich zum Abtriebselement 23 benötigt.

Bei den beiden Schwingungsantrieben 10, 10a gemäß Fig. 1 und 2 sind die Schwingungsantriebe 10, 10a jeweils ortsfest, das heißt zum Beispiel an einem feststehenden Karosserieteil eines Kraftfahrzeugs befestigt. Bei dem in Fig. 3 dargestellten dritten Ausführungsbeispiel der Erfindung ist hingegen der Schwingungsantrieb 10b an dem zu bewegenden Objekt 35, beispielsweise der Fensterscheibe, unmittelbar oder indirekt befestigt, und wird mit diesem zusammen bewegt. Demgegenüber sind die beiden Abtriebselemente 30a, 31 a ortsfest angeordnet. Ansonsten ist die Funktionsweise entsprechend dem Schwingungsantrieb 10a, wobei beim Schwingungsantrieb 10b dieser beim Betrieb zusammen mit dem Objekt 35 in Richtung des Doppelpfeils 36 bewegt wird.

Ergänzend wird erwähnt, dass bei den dargestellten Ausführungsbeispielen die Piezoaktuatoren 13, 14; 13a, 14a jeweils rechtwinklig zueinander angeordnet sind, wobei der Piezoaktuator 13; 13a mit seiner Längsachse jeweils parallel zur Bewegungsrichtung des zu bewegenden Gegenstands (Abtriebselemente 23; 30, 31 bzw. Objekt 35) und der andere Piezoaktuator 14; 14a senkrecht dazu angeordnet ist. Mit anderen Worten ausgedrückt ist jeweils einer der beiden Piezoaktuatoren 13, 14; 13a, 14a ausschließlich für den Vorschub und der andere der Piezoaktuatoren 13, 14; 13a, 14a jeweils ausschließlich für das Halten des zu bewegenden Gegenstands (Abtriebselemente 23; 30, 31 bzw. Objekt 35) verantwortlich. In Abänderung dieser Ausführungsformen fällt es jedoch auch in den Rahmen der Erfindung, dass die beiden Piezoaktuatoren 13, 14; 13a, 14a auch in einem schrägen Winkel zueinander angeordnet sein können. Auch ist es denkbar, dass bei einer rechtwinkligen Anordnung der beiden Piezoaktuatoren 13, 14; 13a, 14a diese nicht parallel bzw. rechtwinklig zur Bewegungsrichtung des zu bewegenden Gegenstands angeordnet sind. In diesem Fall können zusätzliche Vorschub- bzw. Haltekräfte bei der Ansteuerung der Piezoaktuatoren 13, 14; 13a, 14a auf den zu bewegenden Gegenstand entstehen, die entweder anderweitig kompensiert, oder aber zusätzlich genutzt werden können. Erfindungswesentlich ist lediglich, dass der eine der beiden Piezoaktuatoren 13, 14; 13a, 14a an einer freien Stirnseite des anderen Piezoaktuators 13, 14; 13a, 14a angeordnet bzw. befestigt ist und letzterer keine direkte Befestigung an einem ortsfestem Objekt aufweist.

Abschließend sei noch auf die Federn 37 verwiesen, die für eine ausreichende Kontaktkraft zwischen dem Piezoaktuator 14a und den diesem zugeordneten Abtriebselementen 30, 31 bzw. 30a, 31 a sorgen.

## Patentansprüche

1. Schwingungsantrieb (10; 10a; 10b), insbesondere für Kraftfahrzeuganwendungen, mit wenigstens zwei zu Schwingungen anregbaren Antriebselementen (11, 12), welche in Wirkverbindung mit wenigstens einem Abtriebselement (23; 30, 31; 30a, 31a) angeordnet sind,
**dadurch gekennzeichnet,**
**dass** das erste der wenigstens zwei Antriebselemente (11) mit einer Seite (17) mit einem ortfesten oder zu bewegenden Objekt (18; 35) verbunden ist, und dass das zweite der wenigstens zwei Antriebselemente (12) ausschließlich an dem ersten Antriebselement (11) an dessen dem ortsfesten oder zu bewegenden Objekt (18; 35) gegenüberliegenden Seite befestigt ist.

2. Schwingungsantrieb nach Anspruch 1,
**dadurch gekennzeichnet,**
**dass** die beiden Antriebselemente (11, 12) bezüglich ihrer Schwingungsrichtungen (Doppelpfeile 26, 27) rechtwinklig zueinander angeordnet sind, und dass die Schwingungsrichtung (Doppelpfeil 26) des ersten Antriebselements (11) parallel zur Bewegungsrichtung (Doppelpfeil 25; 36) des wenigstens einen Abtriebselements (23; 30, 31) bzw. des zu bewegenden Objekts (35) angeordnet ist.

3. Schwingungsantrieb nach Anspruch 1 oder 2,
**dadurch gekennzeichnet,**
**dass** das zweite Antriebselement (12) an einem Endbereich des ersten Antriebselements (11) angeordnet ist.

4. Schwingungsantrieb nach Anspruch 1 oder 2,
**dadurch gekennzeichnet,**
**dass** das zweite Antriebselement (12) mittig am ersten Antriebselement (11) angeordnet ist.

5. Schwingungsantrieb nach einem der Ansprüche 1 bis 4,
**dadurch gekennzeichnet,**
**dass** das wenigstens eine Abtriebselement (23; 30, 31) bzw. das zu bewegende Objekt (35) zumindest mittelbar mit einem Fenster eines Kraftfahrzeugs verbunden ist.

6. Schwingungsantrieb nach einem der Ansprüche 1 bis 5,
**dadurch gekennzeichnet,**
**dass** die wenigstens zwei Antriebselemente (11, 12) als Piezoaktuatoren (13, 14; 13a, 14a) ausgebildet sind.

7. Schwingungsantrieb nach Anspruch 6,
**dadurch gekennzeichnet,**
**dass** die wenigstens zwei Piezoaktuatoren (13, 14; 13a, 14a) an ihrer Verbindungsstelle durch Kleben, Sintern, Löten oder Klemmen miteinander verbunden sind.

8. Schwingungsantrieb nach Anspruch 6 oder 7,
**dadurch gekennzeichnet,**
**dass** die wenigstens zwei Piezoaktuatoren (13, 14; 13a, 14a) zeitlich versetzt, insbesondere mit einer Phasenverschiebung von 90 Grad, zueinander angesteuert werden.

9. Schwingungsantrieb nach einem der Ansprüche 6 bis 8,
**dadurch gekennzeichnet,**
**dass** zumindest einer der Piezoaktuatoren (14; 14a) zum Halten des Abtriebselements (23; 30, 31) bzw. des zu bewegenden Objekts (35) als nach dem d31-Effekt arbeitender Piezoaktuator (14; 14a) ausgebildet ist.

10. Schwingungsantrieb nach einem der Ansprüche 6 bis 9,
**dadurch gekennzeichnet,**
**dass** die Piezoaktuatoren (13, 14; 13a, 14a) als Vielschichtaktuatoren ausgebildet sind.
